# EUROPÄISCHE PATENTANMELDUNG

(11) **EP 2 421 348 A2**
(43) Veröffentlichungstag der Anmeldung: **22.02.2012**
(21) Anmeldenummer: 11005971.4
(22) Anmeldetag: 21.07.2011
(51) Int. Cl.: H05K 7/18

(54) **Verteilerschrank**

(30) Priorität: 17.08.2010 DE 102010034620
(71) Anmelder: ADC GmbH, 14167 Berlin (DE)
(72) Erfinder: Birkenstock, Oliver, Dipl.-Ing., 14050 Berlin (DE); Benedetto, Adrian, Dipl.-ing., 12103 Berlin (DE); Meyer, Philipp, Dipl.-Ing., 10969 Berlin (DE)

(57) **Zusammenfassung**

Die Erfindung betrifft einen Verteilerschrank für die Kommunikations- und Datentechnik, wobei der Verteilerschrank untere horizontale Querstreben (1) eines Gestells und mindestens eine Bodenplatte (10) aufweist, wobei die Bodenplatte (10) mit mindestens einer unteren horizontalen Querstrebe (1) verbunden ist, wobei die Bodenplatte (10) mindestens eine auf der Unterseite (12) angeordnete umlaufende Dichtung (19) und mindestens eine über den äußeren Rand vorstehende Rastlasche (18) aufweist, wobei die unteren Querstreben (1) mindestens eine in den Verteilerschrank gerichtete Auflage (6) mit einer Dichtungskante (7) aufweisen, wobei mindestens die an die Rastlasche (18) angrenzende Querstrebe (1) eine Rastaufnahme aufweist, in die die Rastlasche (18) eintaucht, wobei die Rastlasche (18) auf die Querstrebe (1) eine Kraft ausübt, so dass die Dichtungskante (7) gegen die umlaufende Dichtung (19) der Bodenplatte (10) gepresst wird, sowie eine Bodenplatte für einen Verteilerschrank für die Kommunikations- und Datentechnik.

## Beschreibung

Die Erfindung betrifft einen Verteilerschrank für die Kommunikations- und Datentechnik sowie eine Bodenplatte für einen Verteilerschrank.

Ein solcher Verteilerschrank ist beispielsweise aus der DE 10 2008 056 062 B3 bekannt. Der Verteilerschrank weist ein Gestell auf, an dem mindestens ein Dachmodul, Seitenwände, mindestens eine Rückwand und mindestens eine Tür angeordnet sind. Das Gestell weist vertikale Streben und untere und obere horizontale Streben auf, wobei das Dachmodul an den oberen horizontalen Streben befestigt ist. An den unteren Querstreben ist eine Bodenplatte befestigt, durch die über Dichtungen Kabel aus dem Boden in den Verteilerschrank geführt werden können. Die Befestigung der Bodenplatte an den Querstreben erfolgt üblicherweise durch Verschraubungen.

Der Erfindung liegt das technische Problem zugrunde, die Montage eines Verteilerschrankes zu vereinfachen und eine hierfür geeignete Bodenplatte zu schaffen.

Die Lösung des technischen Problems ergibt sich durch die Gegenstände mit den Merkmalen der Ansprüche 1 und 6. Weitere vorteilhafte Ausgestaltungen der Erfindung ergeben sich aus den Unteransprüchen.

Hierzu weist der Verteilerschrank für die Kommunikations- und Datentechnik untere horizontale Querstreben eines Gestells und mindestens eine Bodenplatte auf, wobei die Bodenplatte mit mindestens einer unteren horizontalen Querstrebe verbunden ist, wobei die Bodenplatte mindestens eine auf der Unterseite angeordnete umlaufende Dichtung und mindestens eine über den äußeren Rand (bzw. den Seiten) vorstehende Rastlasche aufweist, wobei die unteren Querstreben mindestens eine in den Verteilerschrank gerichtete Auflage mit einer Dichtungskante aufweisen, wobei mindestens die an die Rastlasche angrenzende Querstrebe eine Rastaufnahme aufweist, in die die Rastlasche eintaucht, wobei die Rastlasche auf die Querstrebe eine Kraft ausübt, so dass die Dichtungskante gegen die umlaufende Dichtung der Bodenplatte gepresst wird. Somit wird erreicht, dass die Bodenplatte werkzeuglos montiert werden kann, wobei die Dichtigkeitsanforderungen hinsichtlich Feuchtigkeit eingehalten werden können.

Die mindestens eine Dichtung auf der Unterseite der Bodenplatte kann dabei beispielsweise auf die Bodenplatte aufgeschäumt oder geklebt sein. Weiter sei angemerkt, dass die Dichtung nicht vollständig die Auflage abdecken muss.

In einer Ausführungsform weist die Bodenplatte mindestens an mindestens zwei gegenüberliegenden Seiten jeweils mindestens eine Rastlasche auf. Hierdurch wird die Dichtung symmetrisch angedrückt. Weiter kann vorgesehen sein, dass mehrere Rastlaschen je Seite vorgesehen sind und/oder dass an jeder Seite mindestens eine Rastlasche vorgesehen ist, so dass die Verbindung über alle unteren Querstreben erfolgt.

In einer weiteren Ausführungsform weist die Bodenplatte an der Seite der Rastlasche eine Aufkantung auf, aus der die Rastlasche freigeschnitten ist. Die Aufkantung erhöht dabei die Stabilität der Bodenplatte. Dabei kann auch vorgesehen sein, dass auch an einigen oder allen Seiten ohne Rastlasche Aufkantungen vorgesehen sind.

In einer weiteren Ausführungsform ist die Rastaufnahme als durchgängige Nut ausgebildet. Dies erleichtert die Fertigung der Querstreben beispielsweise als Strangpressprofil.

In einer weiteren Ausführungsform ist die Dichtungskante zylinderförmig bzw. mindestens teilzylinderförmig ausgebildet. Durch die radiale Ausbildung ergibt sich eine kleine Anpresskante, wobei durch die Rundung die Dichtung nicht eingeschnitten wird.

Die Erfindung wird nachfolgend anhand eines bevorzugten Ausführungsbeispieles näher erläutert. Die Fig. zeigen:
- Fig. 1: eine Vorderansicht einer unteren horizontalen Querstrebe,
- Fig. 2: eine perspektivische Seitenansicht der Querstrebe,
- Fig. 3: eine perspektivische Draufsicht auf eine Oberseite einer Bodenplatte und
- Fig. 4: eine Draufsicht auf eine Unterseite der Bodenplatte.

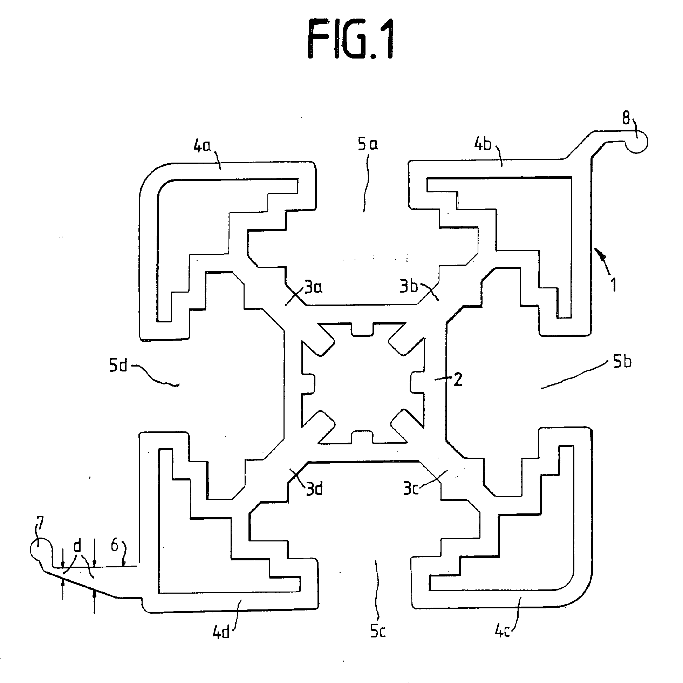

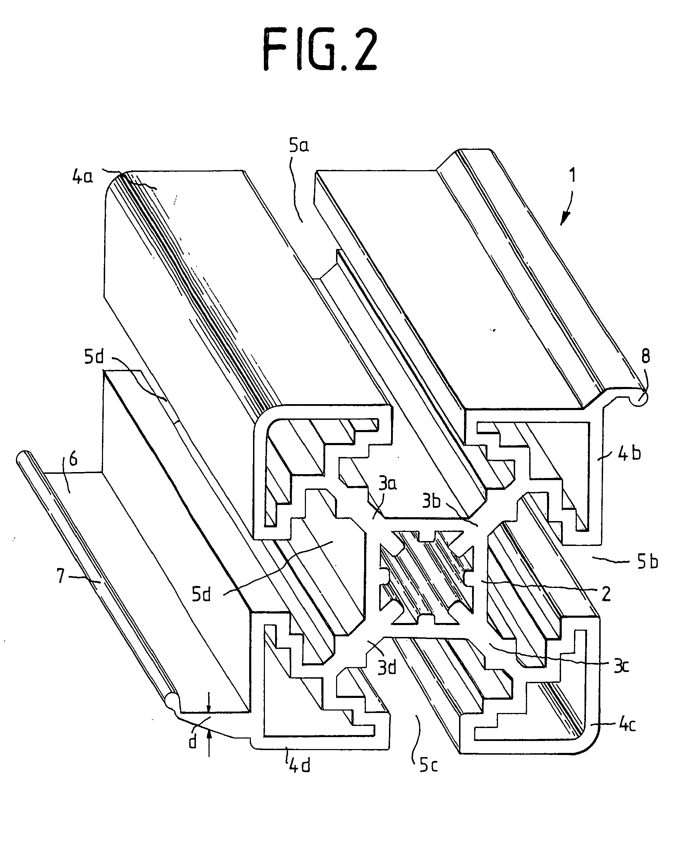

In den Fig. 1 und 2 ist eine untere horizontale Querstrebe 1 dargestellt. Die Querstrebe 1 weist ein Mitteilteil 2 auf, von dem jeweils vier Schenkel 3a-d im Winkel von 45° abgehen, an denen jeweils vier Eckstücke 4a-d angeordnet sind. Die Querstrebe 1 ist dabei derart gestaltet, dass sich eine hohe Stabilität bei geringer Masse ergibt. Zwischen jeweils zwei Eckstücken 4a-d bildet sich dabei eine Nut 5a-d aus. Am linken unteren Eckstück 4d ist eine Auflage 6 angeordnet, an deren Ende eine zylinderförmige Dichtungskante 7 angeordnet ist. Ausgehend von dem Endstück 4d verjüngt sich das Unterteil der Auflage 6, so dass die Auflage 6 im Bereich der Dichtungskante 7 eine geringere Dicke d aufweist. Dies ermöglicht eine gewisse Federwirkung im Bereich der Dichtungskante 7. An dem oberen rechten Eckstück 4b ist eine Anschlagkante 8 angeordnet. An dieser Anschlagkante 8 kann dann definiert je nach Einbauort der Querstrebe 1 eine Rückwand, eine Seitenwand oder eine Tür definiert angeordnet werden.

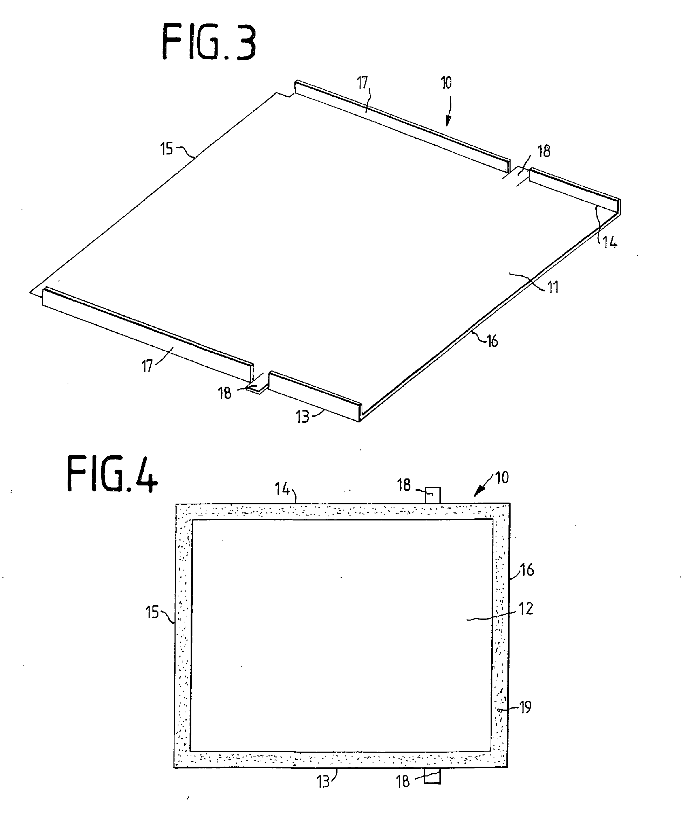

In den Fig. 3 und 4 ist eine Bodenplatte 10 dargestellt. Die Bodenplatte 10 weist eine Oberseite 11, eine Unterseite 12, eine Vorderseite 13, eine Rückseite 14, eine linke Seite 15 und eine rechte Seite 16 auf. An der Vorderseite 13 und an der Rückseite 14 ist jeweils eine Aufkantung 17 angeordnet, aus der jeweils eine Rastlasche 18 freigeschnitten ist. Auf der Unterseite 12 ist eine umlaufende Dichtung 19 angeordnet, die beispielsweise auf die Bodenplatte 10 aufgeschäumt ist.

Zur Montage wird die Bodenplatte 10 von oben mit der Unterseite 12 nach unten gerichtet in Richtung der unteren horizontalen Querstreben 1 bewegt. Dabei werden die Rastlaschen 18 durch die oberen innenliegenden Eckstücke 4a in Richtung der Aufkantung 17 bewegt, um schließlich in die Nut 5d einzutauchen, die sich zwischen dem oberen innenliegenden Eckstück 4a und dem Eckstück 4d mit der Auflage 6 bildet. Gleichzeitig kommt die Dichtung 19 auf der Auflage 6 und der Dichtungskante 7 zum Aufliegen. Dabei presst sich die Dichtungskante 7 in Dichtung 19 und dichtet den Innenraum des Verteilerschrankes ab. Die Rastlasche 18 drückt dabei von innen gegen das innere obere Eckstück 4a und übt somit eine Kraft auf die Querstrebe 1 nach oben aus, was dazu führt, dass die Dichtungskante 7 weiter gegen die Dichtung 18 gepresst wird.

### Bezugszeichenliste

- 1: Querstrebe
- 2: Mitteilteil
- 3a-d: Schenkel
- 4a-d: Eckstück
- 5a-d: Nut
- 6: Auflage
- 7: Dichtungskante
- 8: Anschlagkante
- 10: Bodenplatte
- 11: Oberseite
- 12: Unterseite
- 13: Vorderseite
- 14: Rückseite
- 15: linke Seite
- 16: rechte Seite
- 17: Aufkantung
- 18: Rastlasche
- 19: Dichtung

## Patentansprüche

1. Verteilerschrank für die Kommunikations- und Datentechnik, wobei der Verteilerschrank untere horizontale Querstreben (1) eines Gestells und mindestens eine Bodenplatte (10) aufweist, wobei die Bodenplatte (10) mit mindestens einer unteren horizontalen Querstrebe (1) verbunden ist,
**dadurch gekennzeichnet, dass**
die Bodenplatte (10) mindestens eine auf der Unterseite (12) angeordnete umlaufende Dichtung (19) und mindestens eine über den äußeren Rand vorstehende Rastlasche (18) aufweist, wobei die unteren Querstreben (1) mindestens eine in den Verteilerschrank gerichtete Auflage (6) mit einer Dichtungskante (7) aufweisen, wobei mindestens die an die Rastlasche (18) angrenzende Querstrebe (1) eine Rastaufnahme aufweist, in die die Rastlasche (18) eintaucht, wobei die Rastlasche (18) auf die Querstrebe (1) eine Kraft ausübt, so dass die Dichtungskante (7) gegen die umlaufende Dichtung (19) der Bodenplatte (10) gepresst wird.

2. Verteilerschrank nach Anspruch 1, **dadurch gekennzeichnet, dass** die Bodenplatte (10) mindestens an mindestens zwei gegenüberliegenden Seiten (13, 14) jeweils mindestens eine Rastlasche (18) aufweist.

3. Verteilerschrank nach Anspruch 1 oder 2, **dadurch gekennzeichnet, dass** die Bodenplatte (10) an der Seite (13, 14) der Rastlasche (18) eine Aufkantung (17) aufweist, aus der die Rastlasche (18) freigeschnitten ist.

4. Verteilerschrank nach einem der vorangegangenen Ansprüche, **dadurch gekennzeichnet, dass** die Rastaufnahme als durchgängige Nut (5d) ausgebildet ist.

5. Verteilerschrank nach einem der vorangegangenen Ansprüche, **dadurch gekennzeichnet, dass** die Dichtungskante (7) zylinderförmig ausgebildet ist.

6. Bodenplatte für einen Verteilerschrank für die Kommunikations- und Datentechnik,
**dadurch gekennzeichnet, dass**
die Bodenplatte (10) mindestens eine auf der Unterseite (12) angeordnete umlaufende Dichtung (19) und mindestens eine über den äußeren Rand vorstehende Rastlasche (18) aufweist.
